# EUROPÄISCHE PATENTANMELDUNG

(11) **EP 2 881 998 A2**
(43) Veröffentlichungstag der Anmeldung: **10.06.2015**
(21) Anmeldenummer: 14020079.1
(22) Anmeldetag: 09.11.2014
(51) Int. Cl.: H01L 31/048

(54) **PV-Modul mit besonders hoher Resistenz gegenüber Degradation durch parasitäre elektrische Ströme**

(30) Priorität: 12.11.2013 DE 11318949
(71) Anmelder: Naebauer, Anton, 80805 München (DE)
(72) Erfinder: Naebauer, Anton, 80805 München (DE)

(57) **Zusammenfassung**

Die vorliegende Erfindung betrifft ein Photovoltaik-Modul mit besonders hoher Resistenz g egenüber Degradationen durch parasitäre elektrische Ströme bei dem die im PV-Modul verwendeten Silikatgläser mindestens 3 % (Mol%) Alkaliionen enthalten und der Isolationswiderstand multipliziert mit der Modulfläche mindestens 100 MΩ*m² beträgt.

## Beschreibung

Im Laufe der Betriebszeit von Photovoltaik-Modulen kommt es zu einer Degradation unter anderem des Wirkungsgrades der Photovoltaik-Module.

Zum Teil sind die Ursachen und Wirkungsmechanismen der Degradation bekannt, so dass gezielt Gegenmaßnahmen eingeleitet werden können. In vielen Fällen sind die Effekte aber noch weitgehend unerforscht.

Bei Photovoltaik Solarmodulen (PV-Modulen) kommt es unter bestimmten Umständen zur einer Degradation, die hervorgerufen wird durch die elektrische Spannungsdifferenz die zwischen der Solarzelle und Umgebung herrscht, da die Einkapselung der Solarzellen im PV-Modul die Solarzellen elektrisch nicht vollständig von der Umgebung isolieren kann. Dieser Effekt wird in der Literatur üblicherweise als PotentialInduzierte Degradation (PID) bezeichnet.

Die Auswirkungen sind unterschiedlich je nach Technologie der Solarzelle.

Bei Dünnschichtsolarzellen, die direkt auf dem Frontglas aufgebracht sind, und die ein transparentes leitfähiges Oxid (TCO) an der Vorderseite besitzen, kann es beispielweise zu einer Beschädigung (z. B. Korrosion oder Ablösung) des TCO kommen. Diese Fehler sind schon längere Zeit bekannt. Als Ursache wird vermutet, dass Ionen (insbesondere Alkali Ionen im Glas, das die Zelle abdeckt und gegenüber der Umgebung isoliert) dafür verantwortlich sind. Es wird vermutet, dass die positiv geladenen Alkali Ionen durch das elektrische Feld, das sich zwischen PV-Zelle und Umgebung (dies ist lokal insbesondere dann besonders stark, wenn das Modul gerahmt ist, und der Rahmen geerdet ist, und die Frontscheibe des Moduls feucht ist, so dass ein geringer elektrischer Strom auf der feuchten äußeren Glasschicht fließen kann) aufbaut dafür sorgt, dass die Alkali-Ionen zur TCO-Schicht wandern und diese schädigen.

In vielen Fällen wird dieser Art der Degradation entgegengewirkt durch die Vorschrift, dass der PV-Modulstrang am negativsten Punkt geerdet werden muss. Dadurch wird erreicht, dass die Umgebung (Erde) gegenüber den PV-Zellen in der Regel elektrisch negativer ist. Damit fließen die positiv geladenen Alkali Ionen im Glas von den positiv geladenen Zellen in Richtung der negativen Polarität (Umgebung, "geerdet" Außenseite des Glases) und damit von den Zellen weg. Bisher ist noch nicht bekannt, ob durch diesen Strom von Alkaliionen nach außen nicht andere degradierende Effekte verursacht werden.

Neuer ist, dass auch PV-Module, die aus Silizium Wafer-zellen aufgebaut sind (umgangssprachlich: kristalline PV-Module), eine Potentialinduzierte Degradation aufweisen. Je nach Aufbau der kristallinen Zelle kann es hier zu einer Degradation kommen sowohl bei hohem positivem als auch hohem negativem Potential der Zelle gegenüber der Umgebung. Er wird vermutet, dass die PID bei positivem Zell-Potential (diese Art der PID wurde erstmalig bei den rückseitig kontaktierten Zellen der Firma Sunpower mit n-dotiertem Grundmaterial festgestellt) gegenüber der Umgebung durch einen Polarisationseffekt der Zelle zu erklären ist, wobei sich auf der isolierten Zelloberfläche negative Ladungen ansammeln, deren elektrisches Feld die Funktion der Zelle beeinträchtigt.

Bei der PID bei negativem Zell-Potential gegenüber der Umgebung (diese wurde erst später bei den weitest verbreiteten Zellen mit beidseitiger Kontaktierung und p-dotiertem Grundmaterial entdeckt) spielen vermutlich wieder (wie bei den Dünnschichtmodulen) die Alkali-Ionen, die im Glas wandern (in diesem Fall wieder in Richtung der Zellen) eine entscheidende Rolle.

Gemeinsam ist allen genannten Arten der Degradation, dass parasitärer elektrischer Stromfluss durch die Einkapselung (Glas) eine wesentliche Rolle spielt, wobei dem Stromtransport durch die Alkali-Ionen im Glas durch das elektrische Feld, das zwischen Zelle und Umgebung wirkt, eine wesentliche Rolle zukommt.

Bei Dünnschichtzellen, bei denen die TCO Korrosion verhindert werden muss, wird vielfach zwischen Glas und TCO eine Barriere gegenüber dem Ionenstrom eingebaut (DE102006062092) oder es wird die Barriere-Wirkung der zur Zelle gehörenden Antireflexschicht ausgenutzt um die Schädigung der Zellen zu vermindern.

Kristalline Zellen, sind in der Regel nicht im direkten Kontakt zum Glas, sondern sind vollständig von einem Einbettungsmaterial (z. B. EVA: Ethylen Vinyl Acetat) umgeben. Weiterhin ist gegenwärtig noch nicht vollständig geklärt, wie der genaue Ursachen-Wirkungszusammenhang für das Auftreten der Schädigung ist. Vielmehr ist klar, dass die Schädigung durch ein ungünstiges Zusammenwirken von mehreren Faktoren verursacht wird.

Ein parasitärer Stromfluss durch das Frontglas ist jedoch in der Regel ein entscheidender Faktor. An dieser Stelle sei erwähnt, dass die Effekte, die zur Degradation eines PV-Moduls führen vielfach noch nicht erkannt und erforscht sind. Insbesondere müssen neben dem reinen elektrischen Stromfluss auch elektrochemische Effekte an den Grenzflächen (Umwelt - Glas, Glas - Einbettungsmaterial; Einbettungsmaterial - Waferzelle ....) betrachtet werden, sowie in Kombination auch Effekte, die durch Licht zusätzlich aktiviert werden.

In diesem Zusammenhang soll auch das Phänomen der Schneckenspuren (eine Verfärbung der leitenden Kontaktfinger auf der Zelloberfläche) erwähnt werden, deren Ursachen noch nicht erforscht sind, die jedoch bevorzugt in Verbindung mit Mikrorissen auftreten, und bei deren Entstehung möglicherweise auch elektrochemische Reaktionen auftreten können. Da im Zusammenhang mit diesen Problemen unter anderem auch Chlor und Schwefel gefunden wurde stellt sich die Frage, wie diese Stoffe dorthin gelangen. Die Antwort könnte auch hier sein, dass diese Stoffe, die im Glas in geringer Konzentration vorhanden sind durch elektrochemische Vorgänge aus dem Glas herausgelöst werden und infolge der hohen elektrischen Felder in ionischer Form zu den Zellen transportiert wird. Dies soll nur beispielhaft zeigen, das durch den parasitären elektrischen Strom auch parasitäre elektrochemische Vorgänge und ein Teichentransport (z. B. in Ionischer Form) erfolgen kann, der langfristig zu einer Degradation der Solarzellen bzw. des PV-Moduls führen kann.

Der Erfindung liegt die Aufgabe zu Grunde die PID und andere, die Performance von PV-Modulen degradierende parasitäre Effekte, die durch parasitäre elektrische Ströme hervorgerufen werden zu vermindern. Dies wird erfindungsgemäß dadurch gelöst, dass die Gläser (Frontglas und gegebenenfalls auch Rückglas) des PV-Moduls aus einem elektrisch besonders gut isolierendem Glas hergestellt werden.

Die Leitfähigkeit von Gläsern für die Photovoltaik ist praktisch kein Auswahl Kriterium. In den bei weitem wenigsten Fällen wird in Spezifikationen oder Datenblättern von für PV-Module zu verwendenden Gläsern die elektrische Leitfähigkeit überhaupt angegeben. Auch ist die elektrische Leitfähigkeit bei den Modulherstellern keine Größe die bei der Eingangskontrolle oder im Rahmen einer routinemäßigen Qualitätskontrolle überwacht wird.

In Bezug auf elektrische Isolation ist Quarzglas, das wenig verunreinigt ist ein optimales Glas. Dieses Glas ist ein hervorragender elektrischer Isolator, und beinhaltet typischerweise auch nur sehr wenige leicht bewegliche Ionen. Die Herstellung eines solchen Glases ist jedoch deutlich teurer als die Herstellung der üblicherweise verwendeten Kalk-Natron Gläser. Dies beruht unter anderem darauf, dass bei der Herstellung der Glasschmelze deutlich höhere Temperaturen erforderlich sind.

In den für PV-Module maßgeblichen Normen IEC-EN-DIN 61215 (für kristalline PV-Module) und IEC-EN-DIN 61646 (für Dünnschicht Solar Module) ist ein Minimum für den Isolationswiderstand vorgeschrieben, das nicht unterschritten werden darf: Für PV Module mit einer Fläche >0,1 m² darf der gemessene Isolationswiderstand multipliziert mit der Modulfläche nicht weniger als 40 MΩ•m² sein, wobei bei ca. 22°C und bei mindestens 500 V oder maximaler Systemspannung in einem leitendem Flüssigkeitsbad zu messen ist.

Mit Hilfe der erfindungsgemäßen Maßnahmen soll der Isolationswiderstand mindestens um den Faktor 2 oder 2,5 - besser sogar um einen Faktor 5 ... 50 gegenüber den erwähnten Normen IEC-EN-DIN 61215 und IEC-EN-DIN 61646 verbessert werden.

Die in der Photovoltaik am häufigsten verwendeten Gläser sind Kalk-Natron Gläser, die bezüglich elektrischer Isolation nicht optimal sind.

Es wird allgemein angenommen (dies kann z. B. auch aus Versuchen abgeleitet werden, die unter anderem in Helmut Mehrer 2006 in "Diffusion and Ionic Conduction in Oxide Glases" dargestellt hat), dass für die elektrische Leitfähigkeit im Glas in erster Linie die Alkali und nicht die Erd-Alkali-Komponente verantwortlich ist. Wenn Strom im Glas fließt, dann fließt dieser hauptsächlich als Ionenstrom von Alkali-Ionen, wobei die in Folge des Stromflusses fließenden Ionen auch zur Degradation des Moduls beitragen können.

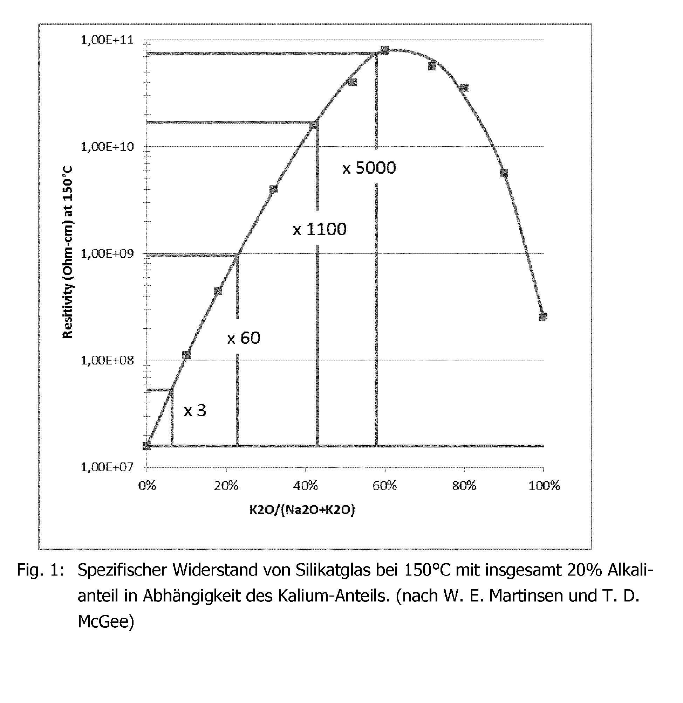

Infolge des angenommenen Leitungsmechanismus variiert der elektrische Widerstand eines Glases mit der Temperatur gemäß dem Arhennius-Gesetz. Die Leitfähigkeit bei Kalk-Natron Glas, ist im Wesentlichen beeinflusst durch die Dichte der im Glas enthaltenen Natrium-Ionen sowie durch die für die Bewegung im Glas erfoderliche "Aktivierungsenergie". Daraus ergibt sich, dass die Leitfähigkeit mit der Temperatur stark zunimmt. Bei Gläsern bei denen gleichzeitig mindestens zwei Alkali-Ionen vorhanden sind kann ein deutlicher "Mixed-Alkali-Effekt" beobachtet, der bezogen auf die Leitfähigkeit am einem speziellen Beispiel mit Natrium und Kalium Folgendes aussagt. Sind im Glas nur x% Natrium Ionen so hat man eine gewisse für die Konzentration der Natrium-Ionen spezifische Leitfähigkeit. Sind im Glas die Natrium-Ionen durch Kalium-Ionen ersetzt (also x% Kalium Ionen), so hat man eine für die Kalium-Ionen spezifische Leitfähigkeit (da die Kalium Ionen größer und schwerer sind als die Natrium Ionen wird eine deutlich kleinere Beweglichkeit und Leitfähigkeit erwartet, was auch zutrifft). Sind im Glas etwa gleich viele Kalium Ionen wie Natrium Ionen (wobei die Summe wieder x% ergibt), so ergibt sich eine Leitfähigkeit, die deutlich unter der erwarteten ist. Von W. E. Martinsen und T. G. McGee werden in Electrical Resistivity and Structure in Glasses in the xK₂O • (1-x)Na₂O • 4SiO₂ System" Messungen zitiert, die zeigen, dass ein Glas in dem die Natrium und Kalium in etwa gleicher Konzentration vorkommen einen um ein vielfaches höheren (kann bis zu einigen Größenordnungen betragen!) Widerstand hat als wenn bei gleicher Gesamt-Konzentration von Alkali Ionen nur Natrium Ionen oder nur Kalium Ionen im Glas wären. In Fig. 1 werden beispielhaft die Messergebnisse von W. E. Martinsen und T. G. McGee gezeigt. Unter den Bedingungen (150°C; Silikatglas) ist zu erkennen, dass der maximale spezifische elektrische Widerstand erreicht wird, wenn das molare Verhältnis zwischen Kalium zu Natrium etwa 60%/40% beträgt. Es ist einleuchtend, dass das Optimum näher auf der Kaliumseite liegt, da Kalium Ionen in Glas gegenüber Natrium Ionen (wegen Gewicht und Größe) eine geringere Beweglichkeit haben.

Das am weitesten gebräuchlich Glas, das Kalk-Natron Glas beinhaltet beispielsweise zu 72% SiO₂, zu 12% Na₂O, zu 11% CaO, zu 4% MgO und zu 1% Al₂O₃ (Prozentangaben beziehen sich - wie es in diesem Dokument die Regel ist - auf Mol%; die genaue Zusammensetzung kann abweichen; weitere Bestandteile können in geringem Umfang ebenfalls enthalten sein). Kalium ist damit kein Hauptbestandheil des Glases. Würde hier etwa die Hälfte des Na₂O durch K₂O ersetzt werden, würde aufgrund des Mixed-Alkali Effektes die Ionenleitfähigkeit und damit die elektrische Leitfähigkeit drastisch sinken. Ein aus einem derartigen Glas aufgebautes kristallines PV-Modul hätte weitaus geringere Leckströme, wodurch auch alle Effekte, die durch parasitäre Ströme hervorgerufen werden deutlich unterdrückt werden können. Insbesondere ist die PID einer der Effekte, die gegenwärtig ein großes Problem für die Langzeit Zuverlässigkeit darstellen.

Unter Glassproperties.com wird von Alexander Flügel ein Berechnungstool für die Berechnung der Temperatur des "working point", die dadurch definiert ist, dass der dekadische Logarithmus der Viskosität in (Pa * s) den Wert 3 hat (log10(visc./(Pa*s)) =3).

Diese Temperatur bestimmt wesentlich die Arbeitstemperatur und den Energieverbrauch (und damit auch die Kosten) bei der Glasherstellung.

Bei Kalk-Natron - Glas mit der Zusammensetzung (in Mol%) 74,3% SiO₂, 14% Na₂O, 10% CaO, 1,7% Al₂O₃ ergibt sich näherungsweise ein Wert von 1045°C für die Temperatur des "working point". Für ein anderes Glas, das als Eisen-armes Glas speziell für die Photovoltaik spezifiziert ist, und dessen Zusammensetzung etwa wie folgt ist (in Mol%) 71% SiO₂, 12,7% Na₂O, 9,4% CaO, 6,4% MgO ergibt sich eine Temperatur für den "working point" von 1030°C.

Modifiziert man die erste Glassorte etwas, wobei fast die Hälfte des Natriumoxids durch Kaliumoxid ersetzt wird, dann ergibt sich nach oben erwähntem Simulationstool eine Temperatur für den "working point" von ca. 1057°C (74% SiO₂, 8 % Na₂O, 6% Ka₂O, 10% CaO, 1,7% Al₂O₃). Auf die Eigenschaften dieser Glasmischung wird im Folgenden unter dem Namen Mixed Alkali 3 noch eingegangen.

Auch wenn die Vorhersage des verwendeten Berechnungstools sicherlich mit Fehlern behaftet ist, so kann man daraus doch schließen dass in den geschilderten Fällen durch die Veränderung des Mischungsverhältnisses in Richtung der ausgewogenen Präsenz von Na und Ka im Glas eine relativ moderate Erhöhung der Temperaturen eingetreten ist (diese Temperaturen sind ein wesentlicher Faktor der Kosten bei der Glasherstellung), so dass die Kosten für die Produktion der mit den modifizierten Mischungsverhältnissen hergestellten Gläser nicht wesentlich teurer sein sollte, als die der Standard Gläser, da sich ja auch die Kosten für Ka₂O und Na₂O nicht so sehr unterscheiden.

Das Ziel ein Glas mit gegenüber Kalk-Natron-Glas deutlich verringerter elektrischer Leitfähigkeit zu fertigen kann einfach durch andere Glasmischungen, insbesondere durch sogenannte Alkali-freie Gläser erreicht werden. Dies ist jedoch unter Kostenaspekten nicht der günstigste Weg.

Grund ist, dass die Alkalianteile im Glas, z. B. Kalium und Natrium während der Glasherstellung wichtige Aufgaben erfüllen (Läuterungsmittel) und auch dazu betragen die bei der Glasherstellung erforderlichen Temperaturen gering zu halten.

Aus diesem Grund werden hier insbesondere auch Glasmischungen vorgeschlagen, die einen gewissen Alkalianteil beinhalten.

Erfindungsgemäß sollte daher das Glas für das PV-Modul einen Alkalianteil (Li₂O, Na₂O, K₂O, Rb₂O, Cs₂O, Fr₂O) zwischen 1 % und 16% (Mol%) aufweisen, wobei die am stärksten vertretene Alkalikomponente nicht mehr als 95 % (Mol%) aller Alkalikomponenten ausmachen darf. (Beispiel: Natriumoxid 8 %; Kaliumoxid 2 %, 90% Siliziumdioxid -> Alkalianteil in Summe: 10%; die am stärksten vertretene Komponente Natrium macht 80 % aller Alkalikomponenten aus, so dass es sich hier um eine erfindungsgemäße Glasmischung handelt). Um den Mixed-Alkali-Effekt noch besser zu nutzen ist anzustreben, dass die am stärksten vertretene Alkalikomponente maximal 80% oder noch besser maximal 70% oder aller Alkalikomponenten ausmachen darf. Diese Regeln gelten insbesondere für Silikat-Glas, das einen Siliziumdioxidanteil (Mol%) von über 50% besser noch über 60% oder noch besser über 65% aufweist. Es ist zu erwarten, dass diese Regeln mit denen unter Ausnutzung des Mixed-Alkali-Effekts vorteilhaft Glas mit geringer elektrischer Leitfähigkeit hergestellt werden kann, auch für andere Gläser gelten und auch dort angewandt werden können. Unter anderem haben H. Mehrer, A. Imre und E. Tanguep-Nijokep in "Diffusion and Ionic Conduction in Oxide Glases" den Mixed Alkali-Effekt in Bor-Gläsern beschrieben, wobei Borgläser mit unterschiedlicher Beimischung von Natriumoxid und Rubidiumoxid betrachtet wurden und auch hier eine Veränderung der elektrischen Leitfähigkeit um mehrere 10er Potenzen durch Änderung des molaren Mischungsverhältnisses Rubidium/Natrium gezeigt werden konnte. Daher ist zu erwarten, dass die hier offenbarte Technik der Herstellung von Gläsern für die Photovoltaik immer dann angewandt werden kann, wenn in einem Glas die Alkali-Ionen für die elektrische Leitfähigkeit verantwortlich sind.

Zur Unterstützung des Mixed-Alkali-Effekts können noch weitere "AlkaliKomponenten" dem Glas zugegeben werden, vorzugsweise in Form von Oxiden von Rubidium, Cäsium oder auch Francium. Diese Elemente weisen, wenn sie als Ionen im Glas vorliegen aufgrund der hohen Atomgewichts und der relativ großen Ionenradien eine deutlich geringere Beweglichkeit (was auch eine geringere elektrische Leitfähigkeit bedeutet) auf als Natrium oder auch Kalium. Diese Stoffe sollten insbesondere dann zugesetzt werden, wenn dadurch bei der Glasherstellung eine vorteilhaftere Prozessführung (z. B. durch geringere Arbeitstemperaturen) erreicht werden kann und somit das Glas besonders kostengünstig hergestellt werden kann. Insbesondere auch wenn sehr hohe elektrische Widerstandswerte angestrebt werden ist dies eine sehr Erfolg versprechende Technik.

Lithium sollte wegen seiner relativ hohen Beweglichkeit nur in sehr geringem Umfang im Glas vorhanden sein wobei gelten muss, dass der Anteil des Lithiums nicht mehr als 50% des Alkalianteils des Glases ausmachen darf.

In Tabelle 1 sind beispielhaft einige Mischungsverhältnisse für Gläser zusammengestellt, an Hand derer die erwartete Wirksamkeit der erfindungsgemäßen Maßnahmen zur Erhöhung des spezifischen elektrischen Widerstands dargestellt werden soll. Die Beispiele für erfindungsgemäße Gläser werden hierbei mit einem Kalk-Natron-Glas verglichen.

Um die Beispiel einfach zu halten wird nur mit Natrium und Kalium gearbeitet.

**Tabelle 1: Eigenschaften verschiedener erfindungsgemäßer Gläser im Vergleich zu Kalk-Natron Glas**

| Glassorte | Kalk Natron Glas | Mixed Alkali 1 | Mixed Alkali 2 | Mixed Alkali 3 | Mixed Alkali 4 | Mixed Alkali 5 |
|---|---|---|---|---|---|---|
| Haupt-Bestandteile (Mol%) | | | | | | |
| SiO₂ | 74,3 % | 74,3 % | 74,3 % | 74,3 % | 76,4 % | 74,1 % |
| Al₂O₃ | 1,7 % | 1,7 % | 1,7 % | 1,7 % | 0,6 % | 0,9 % |
| Na₂O | 14 % | 13,1 % | 10,8 % | 8 % | 3,8 % | 1,75 % |
| K₂O | | 0,9 % | 3,2 % | 6 % | 5,2 % | 2,5 % |
| CaO | 10 % | 10 % | 10 % | 10 % | 11 % | 14,8 % |
| MgO | | | | | 3 % | 6 % |
| Working point Temperatur (log₁₀(visc./(Pa*s)) =3). | 1045°C | 1043°C | 1047°C | 1057°C | 1123 °C | 1171 °C |
| molarer Kalium-Anteil bezogen auf gesamten Alkali Anteil | 0 | 6% | 23 % | 43 % | 58 % | 59 % |
| molarer Anteil der Haupt-Alkali-komponente | 100% | 94 % | 77 % | 57 % | 58 % | 59 % |
| Geschätzter Faktor der Erhöhung des spez. Widerstands | 1 | 3 | 60 | 1 100 | 5 000 | 10 000 |

Ausgehend vom Kalk-Natron Glas werden nach und nach die Mischungsverhältnisse derart geändert, dass man ein Glas mit einem höheren elektrischen Widerstand erreicht.

Bei Mixed Alkali 1 werden nur etwa 6% der Natrium-Ionen im Glas durch Kalium-Ionen ersetzt. Das Beispiel soll zeigen, dass auch hier schon eine deutliche Erhöhung des spezifischen elektrischen Widerstands bringt. Aus Fig. 1 kann man erkennen, dass sich bei einem Kalium-Anteil von 6 % (bezogen auf die Summe aller AlkaliKomponenten) der spezifische elektrische Widerstand dadurch etwa um den Faktor 3 erhöht, gegenüber dem reinen Kalk-Natron-Silikat Glas! Auch wenn die Widerstandwerte aus dem Diagramm in Fig. 1 nicht exakt übertragbar sind zeigt sich eine klare Tendenz, dass durch den Mixed Alkali-Effekt deutlich höhere elektrische Widerstandswerte erreicht werden können. Diese Erhöhung des elektrischen Widerstands wird gemäß des Simulationstools für die Glasschmelze erreicht, ohne dass dadurch die Temperatur des "working points" wesentlich erhöht wird; wenn man das Ergebnis des Simulationstools als genau zutreffend erachtet, ergibt sich sogar eine geringe Erniedrigung dieser Temperatur!

Bei Mixed Alkali 2 werden 3,25% des Natrium-Anteils durch Kalium ersetzt, wodurch sich ein Kalium zu Natrium-Verhältnis von 23 %/77% ergibt.

Schätzt man mit Hilfe von Fig. 1 die Auswirkung dieser Modifikation ab (Anteil der Kalium Ionen ca. 23%) so erkennt man, dass der spezifische elektrische Widerstand grob um den Faktor 60 höher ist als der des als Ausgangspunkt verwendeten Kalk - Natron Glases. Auch wenn diese Abschätzung sehr grob ist und mit großen Fehlern behaftet ist, so zeigt sich doch dass man mit nur geringen Modifikationen des Mischungsverhältnisses des Glases den spezifischen elektrischen Widerstand sehr vorteilhaft beeinflussen kann. Die unter Mixed Alkali 1 und Mixed Alkali 2 beschriebenen Gläser haben als Vorteil, dass die damit hergestellten Gläser noch unter die Norm DIN-EN 572-1 (Glas im Bauwesen - Basiserzeugnisse aus Kalk-Natron-Silikatglas ... ) fallen, die bis zu 5% (Gewichtsprozent) "Andere" Bestandteile als "Hauptbestandteile" zulässt und mindestens 10% (Gewichtsprozent) Natriumoxid vorschreibt. Die in der Tabelle genannten 3,2% (Mol %) Kaliumoxid entsprechen etwa einem Gewichtsanteil von 4,9 % und liegen damit gerade noch unter dem Limit. Den genannten Mol% von 10,8% Natriumoxid entsprechen in Gewichtsprozent etwa 10,9% und liegen daher noch im Bereich der in DIN-EN 572-1 genannten Grenzen. Weiterhin ist zu erwarten, dass die zur Herstellung dieser Gläser erforderliche Prozessumstellung bei der Glasherstellung nur sehr gering ist. Trotzdem ist zu erwarten, dass in vielen Fällen die erreichte Verbesserung des elektrischen Isolationsverhaltens ausreicht. Sollte die damit erzielte Verbesserung in der Praxis nicht ausreichen, kann man weiterhin Natrium durch Kalium ersetzen bis man schließlich Mixed Alkali 3 erhält. Schätzt man mit Hilfe von Fig. 1 die mit Mixed Alkali 3 (Anteil der Kaliumionen ca. 43% von allen Alkaliionen) zu erwartende Verbesserung des elektrische Widerstand ab, so erkennt man, dass der spezifische elektrische Widerstand ca. drei 10er Potenzen also den Faktor 1000 höher ist als der des als Ausgangspunkt verwendeten Kalk-Natron Glases.

Sollte diese Erhöhung des elektrischen Widerstandes wiederum nicht ausreichen, kann wie in der Tabelle mit Mixed Alkali 4 gezeigt das Verhältnis Kalium zu Natrium noch weiter in Richtung Kalium (bis zu ca. 60% Kaliumanteil) geschoben werden, wodurch man erwarten kann, dass damit noch einmal eine knappe 10er Potenz gewonnen wird - grob geschätzt noch einmal der Faktor 5 (also zusammen genommen der Faktor 5000). Ein Erhöhen des Kaliumanteil über 65 % (molar - bezogen auf den gesamten Alkalianteil) ist den Ziel nicht dienlich und sollte daher möglichst unterlassen werden.

Entsprechend Fig. 1 ist durch weitere Veränderung des Verhältnisses Natrium zu Kalium keine wesentliche Verbesserung mehr möglich. Ist dennoch eine weitere Erhöhung des spezifischen elektrischen Widerstands erforderlich, kann dies durch weiteres Absenken des Alkali-Anteils erfolgen, wodurch im Beispiel dann auch andere Komponenten hinzugemischt werden wie Magnesiumoxid und der Anteil von Calcium ebenfalls erhöht wird. Die erwartet Erhöhung des Widerstands sollte in etwa dem Faktor der Absenkung des Alkali-Anteils entsprechen. Das Mischungsverhältnis dafür ist unter Mixed Alkali 5 in der Tabelle aufgelistet. Damit wird jedoch schon eine deutliche Erhöhung der Temperatur des Working Points erkauft. Die Verbesserung des Isolationswiderstands zwischen Mixed Alkali 4 und Mixed Alkali 5 um den Faktor 2 wird aus der Halbierung des Alkali-Anteils abgeleitet.

Wie schon zuvor, ist diese Veränderung des Mischungsverhältnisses jedoch wieder mit einer deutlichen Erhöhung der Temperatur des Working Points verbunden. Sofern die erreichte Verbesserung immer noch nicht ausreicht, muss man den Alkali-Anteil weiter reduzieren. Bei dieser weiteren Erhöhung ist wird die Abweichung von der Standard Prozessführung der Herstellung eines Kalk Natron Glases immer größer, und es werden immer höhere Prozesstemperaturen benötigt. Da die geforderten gut isolierenden Gläser auch ohne große Absenkung des Alkali-Anteils erzielt ist es nicht notwendig, den Alkali-Anteil auf unter 3 % (Mol %) abzusenken.

Für spezielle Anwendungen, in denen besonders gut isolierende Gläser benötigt werden (z. B. in der Elektronik oder Display-Technik -- siehe EP 0714 862A1) und bei denen Kosten in der Regel eine untergeordnete Rolle spielen werden häufig "Alkali-arme" oder gar Alkali-freie Gläser verwendet, bei denen der Alkali-Anteil in der Regel deutlich unter 1 % (Mol%) liegt. Der geringe Alkali-Anteil führt zu deutlich höheren Schmelztemperaturen und anderen Prozessveränderungen, die die Herstellung derartiger gut isolierender Gläser deutlicher verteuern! Auch ein deutliches Erhöhen des Silikat-Anteils führt (siehe Quarzglas) zu deutlich erhöhten Prozesstemperaturen und Kosten bei der Glasherstellung. Für Solarmodule ist es aber wichtig, dass die Kosten möglichst gering sind. Aus diesem Grunde dürfen bei der Glasherstellung nur Prozesse verwendet werden, die sehr ähnlich den etablierten Massenherstellungsprozessen sind und sehr kosteneffektiv auszuführen sind.

Bei den erfindungsgemäßen Gläsern ist geringe Leitfähigkeit in erster Linie auf den Mixed-Alkali-Effekt zurückzuführen. Bei allen gezeigten Beispielen ist der Alkali-Anteil über 4 % (Mol%). Bezüglich der Anteile von Siliziumdioxid und Kalziumoxid bleiben die erfindungsgemäßen Gläser in dem Rahmen, der durch DIN EN 572-1:2004 vorgegeben ist.

Vollständigkeitshalber sei erwähnt, dass sich mit der Veränderung des Mischungsverhältnisses auch die Chemische Beständigkeit des Glases (hydrolytische Resistenz nach DIN 12111; ISO 719) verbessert hat. Mit einem Simulationstool von Alexander Flügel auf "Glassproperties.com" konnte gezeigt werden, dass bei jedem der in Tabelle 1 aufgeführten erfindungsgemäßen "Mixed-Alkali"-Gläser eine bessere hydrolytische Resistenz zu erwarten ist als bei dem als Vergleich verwendeten Kalk-Natron-Glas.

Die Beispiele zeigen eindrucksvoll, dass bei einem Kalk-Natron-Glas durch gezielte Substitution von Natriumoxid durch Kaliumoxid der spezifische elektrische Widerstand deutlich erhöht werden kann.

Eine Erhöhung des Isolationswiderstands kann auch durch dadurch erreicht werden, wenn die beschriebenen Substitution des Natriums im Glas nicht wie beschrieben ausschließlich durch Kalium sondern gleichzeitig auch durch andere Alkali-Elemente (Lithium, Rubidium, Cäsium oder Francium) erfolgt.

Die hier gezeigte Erhöhung des Isolationswiederstands tritt nicht nur bei einem Kalk-Natron-Glas mit der in der Tabelle gezeigten Zusammensetzung ein. Qualitativ hat die Aussage auch Gültigkeit, wenn die übrigen Bestandteile gegenüber der Tabelle, eine etwas abweichende Zusammensetzung haben. So kann CaO beispielsweise in gewissem Maße durch MgO, SrO oder BaO substituiert werden oder in gleicher Weise Al₂O₃ in gewissem Maße durch B₂O₃ ersetzt werden. Durch die erwähnte Substitution ergeben sich bei der Glasherstellung zusätzliche Freiheitsgrade, die zur Optimierung des Herstellungsprozesses oder zur Optimierung anderer Eigenschaften des Glases genutzt werden können.

Neben den bisher beschriebenen Hauptbestandteilen, sind in den Gläsern noch andere Anteile, die in geringen Mengen vorkommen, die aber durchaus eine bedeutende Rolle spielen können. Für ein Solar-Modul ist es besonders wichtig, dass das FrontGlas eine sehr hohe Transparenz hat. Bei üblichem Kalk-Natron Glas ist häufig das in geringen Mengen vorhandene Eisen für Einbußen der Transparenz verantwortlich. Häufig wird daher eine hohe Transparenz erreicht durch Verwendung von Eisenarmen Rohstoffen (insbesondere Sand!) bei der Glasherstellung.

Beim chemischen Härten von Glas werden im Oberflächen nahen Bereich (bis zu einigen 10 µm) des Kalk-Natron-Silikat Glases die Natrium-Ionen teilweise Kalium Ionen zu ersetzen. Dies geschieht unter anderem durch Einwirkung einer mehrere 100°C heißen Kalium-Ionen reichen Flüssigkeit auf die Gläser für mehrere Stunden. Wie an den Beispielen gesehen, ist damit auch eine Erhöhung des spezifischen elektrischen Widerstandes der Gläser im Oberflächen nahen Bereich zu erwarten. Daraus ist zu erkennen, dass eine chemische Härtung von Gläsern für die Photovoltaik als Nebeneffekt gleichzeitig die Isolationsfähigkeit des Glases positiv beeinflusst. Erfindungsgemäß ist es also von Vorteil, wenn für Photovoltaikmodule chemisch gehärtete Kalk-Natron-Gläser verwendet werden, da diese bessere elektrische Isolationseigenschaften haben, als nicht gehärtete Kalk-Natron Gläser.

Weitere Vorteile, von elektrisch besser isolierten PV-Modulen sollen im Folgenden dargestellt werden.

Nach der für kristallinen PV-Module geltenden Norm (IEC-EN-DIN 61215) muss der Isolationswiderstand eines PV-Modules mindestens 40 MΩ•m² geteilt durch die Fläche des Moduls betragen.

Nach DIN_EN_62446 (VDE 0126-23) (Netzgekoppelte Photovoltaiksysteme - Mindestanforderungen an Systemdokumentation, Inbetriebnahmeprüfung und wiederkehrende Prüfungen) muss der Isolationswiderstand eines PV-Generators bei einem System mit 1000 V mindestens 1 MΩ betragen. Möchte man einen PV-Generator der DIN_EN_62446 erfüllt zusammenstellen aus Modulen, die der Norm (DIN-EN 61215 Entsprechen, dann kann die maximale Fläche eines PV-Generators 40 m² betragen. Bei größeren Flächen ist nicht mehr unter allen Umständen sichergestellt, dass der mindestens geforderte Isolationswiderstand eingehalten wird. An dieser Stelle sei erwähnt, dass die Modulnorm den Nachweise des minimalen Isolationswiderstands bei 22°C fordert und in Flüssigkeit, die alle relevanten Oberflächen bedeckt, während in DIN_EN_62446 die Temperatur und der Kontakt mit Wasser nicht gefordert ist. Trotzdem kann es sein, dass bei warmen Regen, wenn die Module über 22°C warm sind (und daher geringeren Isolationswiderstand haben) und die Oberflächen überwiegend mit Wasser benetzt sind, das über elektrisch leitende Befestigungselemente ein elektrisch leitender Pfad zu Masse hergestellt wird. Damit kann es theoretisch vorkommen, dass auch bei einem 40 m² großem Solargenerator unter ungünstigen Umständen der geforderte Isolationswiderstand von 1 MΩ sogar noch unterschritten wird.

An diesem Beispiel wird klar, dass es nicht möglich ist große PV-Generatoren zusammenzustellen und die Norm DIN_EN_62446 unter allen Bedingungen einzuhalten. Geht man in oben genannten Beispiel mit 40 m² Fläche davon aus, dass die Module einen Wirkungsgrad von 15% haben, so entspricht die 40 m² Grenze einer Leistung von nur ca. 6 kW. Um kosteneffektiv große Solarparks bauen zu können ist anzustreben, dass die Fläche des PV-Generators deutlich größer ist.

Bei gleichzeitiger Einhaltung der Norm kann dies geschehen, wenn sichergestellt ist, dass der Isolationswiderstand der PV-Module deutlich besser wird.

Um Solarparks möglichst kosteneffektiv bauen zu können gibt es derzeit den Trend, die Systemspannung von PV-Anlagen von derzeit typischerweise 1000 V auf 1500 V zu erhöhen. In DIN_EN_62446 ist mit höherer Spannung auch ein höherer Isolationswiderstand gefordert. Damit wird deutlich, dass ein Übergang zu höheren Spannungen erleichtert wird, wenn sichergestellt ist, dass das PV-Modul einen hohen Isolationswiderstand besitzt.

Durch die in dieser Erfindung offenbarten Maßnahmen wird ein Weg aufgezeigt, wie eine Verbesserung um mindestens den Faktor drei besser noch um den Faktor 10 oder 100 oder sogar 1000 erreicht werden kann.

Das Schadenspotential von schlecht isolierendem Glas in Sachen Zuverlässigkeit der Zelle soll anhand von folgendem Beispiel erläutert werden.

Ein 1 m² großes PV-Modul arbeitet bei einem Potential von -800 V gegenüber Masse. Unter der Annahme eines Isolationswiderstands von 40 MΩ fließt ein Leckstrom von 20 µA wobei angenommen wird, dass die Hälfte davon, das sind 10 µA durch das Frontglas fließt sofern dieses mit einem dünnen Flüssigkeitsfilm überzogen ist (z. B. Tau, Regen, ...).

Wenn das PV-Modul jeden Tag während der Betriebszeit 10 000 sek mit einem dünnen leitfähigen Flüssigkeitsfilm überzogen ist und 10 µA Strom fließen dann fließt auf dem genannten Weg jeden Tag eine Ladung von 0,1 As. Mi Hilfe der Faraday Konstante (ca. 100 000 As/mol) kann damit berechnen, dass nach 1000 Tagen 1/1000 Mol Elementarladungen durch das Glas transportiert wurden.

1/1000 Mol Natrium Ionen entsprechen einer Menge von 23 mg Natrium.

Bei den Solarzellen wird angenommen, dass diese eine Dicke von 200 µm haben. Ein Quadratmeter von 200µm dickem Silizium entspricht einem Volumen von 0,2 Liter was etwa einem Gewicht von 0,5 kg entspricht.

Nehmen wir an, dass von den 23 mg Natrium 10 mg in das Halbleiter-Silizium gelangen so ergibt sich (bei Annahmen einer homogenen Verteilung im Silizium) eine Verunreinigung des Siliziums von 20 ppm (bezogen auf das Gewicht). Dies ist ein Vielfaches dessen, was normalerweise in Solarsilizium an Natrium enthalten ist. Nach einer Spezifikation von Wacker Chemie sind für die Polysilicon Chunks für Solaranwendungen gewichtsbezogene Verunreinigungen von 2 ppb (also 1/10000 davon) spezifiziert.

An diesem Beispiel kann man erkennen, dass durch die Leckströme durch das Glas ein extrem großes Schadenspotential gegeben ist, das durch Vermindern der Leckströme durch das Glas natürlich auch vermindert werden kann.

Im Folgenden wird die Erfindung beispielhaft anhand der beiliegenden Figuren erläutert. Es zeigen:
- Fig. 1:: Spezifischer Widerstand von Silikatglas bei 150°C mit insgesamt 20% Alkalianteil in Abhängigkeit des Kalium-Anteils. (nach W. E. Martinsen und T. D. McGee).

Figur 1 zeigt beispielhaft eines von vielen in der Literatur veröffentlichten Diagramme zur Veranschaulichung des Mixed Alkali Effekts. Die meisten in der Literatur zu findenden Beispiele zeigen den Effekt für andere Glasmischungen und für andere Temperaturbereiche. Die dabei beschriebenen Gläser haben in der Regel deutlich andere Zusammensetzungen als das üblicherweise für PV-Module verwendete Kalk-Natron-Glas. Dieses Beispiel gilt für Silikat Glas dem Alkalioxide zugemischt wurden. Auch wenn diesem Glas das im Kalk-Natron vorhandene Kalziumoxid fehlt, und dieses Diagramm für einen anderen Temperaturbereich gilt, ist davon auszugehen, dass die in dieser Erfindung genutzte Erhöhung des elektrischen Widerstandes auch bei Kalk-Natron Glas in dem Temperaturbereich, in dem PV-Module in der Regel betrieben werden (z. B. -30 ... + 80°) gilt.

Ein großes Potential der Erfindung liegt auch darin, dass es damit leicht möglich ist, gut isolierende PV-Module herzustellen, die sowohl an der Vorderseite als auch auf der Rückseite ein Glas haben, was zunächst ein Nachteil ist, da ein für Rückseite verwendetes übliches Kalk-Natron Glas im Vergleich mit einer hochwertigen Rückseitenfolie einen höheren parasitären elektrischen Leckstrom aufweisen kann. Durch Verwendung von Glasmischungen, wie sie hier beschrieben sind, kann der Leckstrom der Module deutlich reduziert werden auch wenn Vorder- und Rückseite aus Glas bestehen: Weiterhin ist es damit möglich, die Dicke der Glasscheiben zu reduzieren, von den heute üblichen 3,2 ... 4 mm auf Beispielsweise 2 mm oder sogar noch darunter auf beispielsweise 1,6 mm. Eine weitere Reduzierung dürfte aus mechanischen Gründen sehr schwer sein, ist aber aus Sicht des elektrischen Leckstroms mit dem erfindungsgemäßen Glasmischungen kein Problem.

Da eine thermische Härtung bei dünnen Gläsern (< 2 mm) immer komplizierter wird könnte gerade bei den dünnen Gläsern eine chemische Härtung, mit dem Nebeneffekt, dass damit auch der Leckstrom sinkt besonders interessant werden.

Dünnere Gläser sind besonders attraktiv, da es damit möglich ist, den Rohstoffeinsatz für eine PV-Modul und das Gewicht und damit auch die Transportkosten zu reduzieren. Mit der erfindungsgemäßen Technik wird damit für PV-Module ein weiterer Weg der Kostenreduktion erschlossen.

## Patentansprüche

1. PV-Modul mit besonders hoher besondere Resistenz gegenüber Degradationen durch parasitäre elektrische Ströme **dadurch gekennzeichnet, dass** die im PV-Modul verwendeten Silikatgläser mindestens 3 % (Mol%) Alkaliionen enthalten und der Isolationswiderstand multipliziert mit der Modulfläche mindestens 100 MΩ*m² beträgt.

2. PV-Modul nach Anspruch 1 **dadurch gekennzeichnet, dass** die Zusammensetzung der für Vorderseite und Rückseite verwendeten Gläser der in DIN EN 572-1:2004 beschriebenen Zusammensetzung für Kalk-Natron Silikat-Gläser entspricht.

3. PV-Modul nach Anspruch 2 **dadurch gekennzeichnet, dass** die Zusammensetzung der für Vorderseite und Rückseite verwendeten Gläser der in DIN EN 572-1:2004 beschriebenen Zusammensetzung für Kalk-Natron Silikat-Gläser entspricht mit Ausnahme des in der Norm auf 5 % (Massenanteil) begrenzten Anteils der "Anderen" Hauptbestandteile.

4. PV-Modul nach Anspruch 1, 2 oder 3, **dadurch gekennzeichnet, dass** der molare Anteil von Kalium bezogen auf den gesamten Alkali-Anteil zwischen 4 % und 10 % liegt.

5. PV-Modul nach Anspruch 1, 2 oder 3, **dadurch gekennzeichnet, dass** gegenüber dem Kalk-Natron- Silikatglas der molare Anteil von Natrium teilweise durch Kalium ersetzt wird wobei der molare Anteil von Kalium bezogen auf den gesamten Alkali-Anteil zwischen 10 % und 30 % liegt.

6. PV-Modul nach Anspruch 5, **dadurch gekennzeichnet, dass** gegenüber dem Kalk-Natron- Silikatglas der molare Anteil von Natrium teilweise durch Kalium ersetzt wird wobei der molare Anteil von Kalium bezogen auf den gesamten Alkali-Anteil zwischen 20 % und 25 % liegt.

7. PV-Modul nach Anspruch 1, 2 oder 3, **dadurch gekennzeichnet, dass** gegenüber dem Kalk-Natron- Silikatglas der molare Anteil von Natrium teilweise durch Kalium ersetzt wird wobei der molare Anteil von Kalium bezogen auf den gesamten Alkali-Anteil zwischen 30 % und 50 % liegt.

8. PV-Modul nach Anspruch 1, 2 oder 3, **dadurch gekennzeichnet, dass** gegenüber dem Kalk-Natron- Silikatglas der molare Anteil von Natrium teilweise durch Kalium ersetzt wird wobei der molare Anteil von Kalium bezogen auf den gesamten Alkali-Anteil zwischen 50 % und 60 % liegt.

9. PV-Modul nach Anspruch 1, 2, 3, 4, 5, 6, 7 oder 8, **dadurch gekennzeichnet, dass** gegenüber dem Kalk-Natronglas der molare Anteil von Natrium teilweise durch ein anderes oder mehrere Alkalielemente ersetzt wird wobei der molare Anteil von Natrium bezogen auf den gesamten Alkali-Anteil zwischen 40 % und 95 % liegt.
